Europäisches Patentamt

European Patent Office

Office européen des brevets

(11) Veröffentlichungsnummer: **0 307 595**
**A1**

## EUROPÄISCHE PATENTANMELDUNG

(21) Anmeldenummer: **88112264.2**

(22) Anmeldetag: **28.07.88**

(51) Int. Cl.⁴: **H03L 7/06**

(30) Priorität: **11.09.87 DE 3730645**

(43) Veröffentlichungstag der Anmeldung:
**22.03.89 Patentblatt 89/12**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Ley, Manfred, Dipl.-Ing.**
**St. Martinerstrasse 39**
**A-9500 Villach(AT)**

(54) **Schaltungsanordnung zur Erzeugung zweier eng benachbarter Frequenzen.**

(57) Zur Erzeugung zweier eng benachbarter Frequenzen ($f_1$, $f_2$) werden zwei, die beiden Frequenzen erzeugende Oszillatoren (10,11) über einen PLL-Kreis (14,15,16) geregelt, indem im PLL-Kreis (14,15,16) ein Vergleich lediglich einer der beiden Frequenzen (beispielsweise $f_1$) mit einer Referenzfrequenz ($f_{ref}$) stattfindet und beide Oszillatoren durch das aus dem Vergleich gewonnene Frequenzvergleich-Ausgangssignal geregelt werden.

EP 0 307 595 A1

FIG 1

## Schaltungsanordnung zur Erzeugung zweier eng benachbarter Frequenzen.

Die vorliegende Erfindung betrifft eine Schaltungsanordnung zur Erzeugung zweier eng benachbarter Frequenzen nach dem Oberbegriff des Patentanspruches 1.

Eng benachbarte bzw. eng nebeneinander liegende Frequenzen kommen beispielsweise bei der Datentastung, der Nulldurchgangsbestimmung von Datensignalen oder bei Taktrückgewinnungen zur Anwendung. Ein Wertebeispiel für eine derartige Frequenz ist beispielsweise eine erste Taktfrequenz von 160,0 MHz und eine zweite um 0,1 bis 0,8 % höhere Taktfrequenz.

Derartige Frequenzen sind bisher durch Verwendung zweier PLL-Kreise (Phase-Locked-Loop-Kreise) mit zwei hochstabilen Quarzoszillatoren zur Erzeugung zweier Referenzfrequenzen für die Regelung von zwei, die gewünschten eng benachbarten Frequenzen erzeugenden Oszillatoren erzeugt worden. Soll eine derartige Schaltungsanordnung als Teil eines hochintegrierten Schaltkreises verwendet werden, so ist eine derartige Lösung wegen der Zahl externer Bauelemente sowie wegen ihres Flächen- und Strombedarfs ungeeignet.

Der vorliegenden Erfindung liegt die Aufgabe zugrunde, eine Schaltungsanordnung der in Rede stehenden Art anzugeben, welche sich zur Verwendung in hochintegrierten Schaltkreisen eignet.

Diese Aufgabe wird bei einer Schaltungsanordnung der eingangs genannten Art erfindungsgemäß durch die Merkmale des kennzeichnenden Teiles des Patentanspruches 1 gelöst.

Weiterbildungen des Erfindungsgedankens sind Gegenstand von Unteransprüchen.

Die Erfindung wird im folgenden anhand von in den Figuren der Zeichnung dargestellten Ausführungsbeispielen näher erläutert. Es zeigt:

FIG 1 ein Blockschaltbild einer generellen Ausführungsform einer erfindungsgemäßen Schaltungsanordnung; und

FIG 2 ein schematisches Schaltbild einer Grundzelle für einen Ringoszillator, die zur Realisierung von Oszillatoren in der Schaltungsanordnung nach FIG 1 besonders geeignet ist.

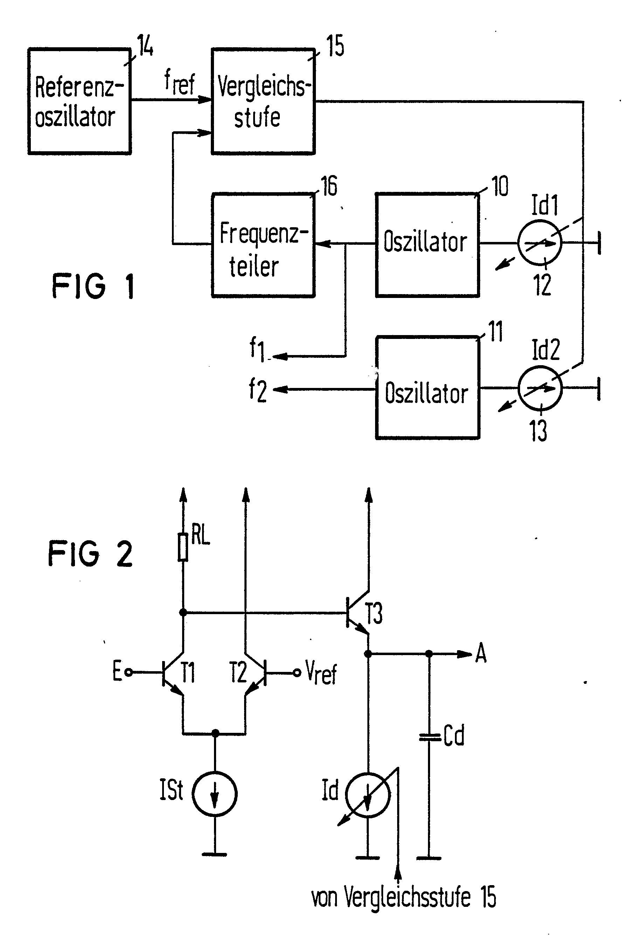

In der Schaltungsanordnung nach FIG 1 sind zwei Oszillatoren 10 und 11 vorgesehen, welche zur Erzeugung zweier eng benachbarter Frequenzen $f_1$ und $f_2$ vorgesehen sind. Zu diesen beiden Oszillatoren 10 und 11 gehört jeweils ein schematisch dargestellter, mit Id1 bzw. Id2 bezeichneter frequenzbestimmender Schaltungsteil, über den die Oszillatoren 10 und 11 in noch zu beschreibender Weise geregelt werden.

Weiterhin ist in der Schaltungsanordnung ein PLL-Kreis 14,15,16 mit einem eine Referenzfrequenz $f_{ref}$ erzeugenden Referenzoszillator 14, einer Vergleichsstufe 15 sowie einem Frequenzteiler 16 vorgesehen. Dem Frequenzteiler 16, der die in ihn eingespeiste Frequenz um einen vorgegebenen Betrag, bei einer Eingangsfrequenz von 160 MHz beispielsweise durch 8 teilt, wird das Ausgangssignal des Oszillators 10 der Frequenz $f_1$ zugeführt. Das durch den Frequenzteiler 16 in seiner Frequenz $f_1$ heruntergeteilte Ausgangssignal des Oszillators 10 wird zusammen mit dem Referenzsignal $f_{ref}$ in die Vergleichsstufe 15 eingespeist, welche ein der Differenz der beiden Eingangsfrequenzen entsprechendes Ausgangssignal erzeugt.

Erfindungsgemäß werden nun die beiden Oszillatoren 10 und 11 durch das Frequenzvergleich-Ausgangssignal der Vergleichsstufe 15 über ihren jeweiligen frequenzbestimmenden Schaltungsteil Id1 bzw. Id2 gemeinsam geregelt. Es entstehen somit zwei quarzstabile Frequenzen $f_1$ und $f_2$, die wertemäßig eng benachbart durch einen frequenzbestimmenden Schaltungsteil der Oszillatoren festgelegt werden können.

Die Oszillatoren 10 und 11 nach FIG 1 sind in Weiterbildung der Erfindung vorzugsweise als aus ECL-Invertern gebildete Ringoszillatoren ausgebildet. Eine Grundzelle für einen derartigen Ringoszillator ist in FIG 2 dargestellt. Sie besteht im Prinzip aus einer Differenzverstärkerstufe und einer dieser nachgeschalteten Emitterfolgerstufe. Ein vollständiger Ringoszillator kann dabei durch mehrere derartige, in Kaskade geschaltete Zellen gebildet werden, die vom Ausgang der letzten Zelle auf den Eingang der ersten Zelle rückgekoppelt sind.

Die Differenzverstärkerstufe wird durch zwei emittergekoppelte Transistoren $T_1$ und $T_2$ gebildet, deren zusammengeschaltete Emitter an einer Stromquelle ISt liegen. Im Kollektorzweig des Transistors $T_1$ liegt ein Lastwiderstand RL, so daß der Verbindungspunkt des Kollektors dieses Transistors und des Lastwiderstandes RL den Ausgang der Differenzverstärkerstufe bildet. Ein Eingang E der Differenzverstärkerstufe wird durch die Basis des Transistors $T_1$ gebildet, während an der Basis des Transistors $T_2$ eine Referenzspannung $V_{ref}$ liegt.

Die Emitterfolgerstufe wurde durch einen Transistor $T_3$ gebildet, der mit seiner Basis am Ausgang der Differenzverstärkerstufe liegt, wobei sein Emitter einen Ausgang 4 des ECL-Inverters bildet. Im Emitterzweig der Emitterfolgerstufe $T_3$ liegt eine steuerbare Stromquelle Id, die beispielsweise als steuerbarer Stromspiegel ausgebildet sein kann und zusammen mit einer ebenfalls am Emitter der Emitterfolgerstufe $T_3$ liegenden Verzögerungskapa-

zität Cd einen frequenzbestimmenden Teil des ECL-Inverters bildet. Durch die von der Vergleichsstufe 15 nach FIG 1 gesteuerte Stromquelle Id wird die Entladezeit der Verzögerungskapazität Cd bestimmt, so daß die Steilheit einer fallenden Flanke des Ausgangssignals des ECL-Inverters direkt vom Strom im Emitterzweig der Emitterfolgerstufe $T_3$ abhängig ist.

In einem integrierten Schaltkreis werden die als Ringoszillatoren im vorstehend erläuterten Sinne ausgebildeten Oszillatoren 10 und 11 nach FIG 1 elektrisch und geometrisch identisch und streng symmetrisch ausgebaut. Damit werden durch den PLL-Kreis 14,15,16 nach FIG 1 für beide Ringoszillatoren Prozeßparametervariationen sowie Temperatur- und Versorgungsspannungsabhängigkeiten durch einen einzigen PLL-Kreis ausgeregelt.

Wie bereits ausgeführt, wird die unterschiedliche Schwingfrequenz der beiden Ringoszillatoren 10 und 11 nur durch die gewollte Abweichung einer frequenzbestimmenden Größe bzw. eines frequenzbestimmenden Schaltungsteiles in einem Ringoszillator erreicht. Zweckmäßigerweise wird dazu die Größe der Verzögerungskapazität Cd nach FIG 2 herangezogen, da diese fertigungstechnisch gut beherrschbar ist.

## Ansprüche

1. Schaltungsanordnung zur Erzeugung zweier eng benachbarter Frequenzen ($f_1$,$f_2$) mit zwei jeweils eine der beiden Frequenzen erzeugenden Oszillatoren (10,11) und mit einem PLL-Kreis (14,15, 16) zur Regelung der Frequenzen ($f_1$,$f_2$), welcher einen Frequenzvergleich mindestens einer der beiden Frequenzen ($f_1$,$f_2$) mit einer Referenzfrequenz ($f_{ref}$) durchführt und die Frequenzen ($f_1$,$f_2$) der beiden Oszillatoren (10,11) als Funktion des Frequenzvergleich-Ausgangssignals des PLL-Kreises (14,15,16) regelt, **dadurch gekennzeichnet,** daß im PLL-Kreis (14,15,16) ein Frequenzvergleich lediglich der Frequenz (beispielsweise $f_1$,) eines Oszillators (beispielsweise 10) erfolgt und daß beide Oszillatoren (10,11) durch das daraus resultierende Frequenzvergleich-Ausgangssignal des PLL-Kreises (14,15,16) geregelt sind.

2. Schaltungsanordnung nach Anspruch 1, **dadurch gekennzeichnet,** daß als Oszillatoren (10,11) durch ECL-Inverter gebildete Ringoszillatoren vorgesehen sind.

3. Schaltungsanordnung nach Anspruch 1 und 2, **dadurch gekennzeichnet,** daß die Frequenzen ($f_1$,$f_2$) der als ECL-Inverter ausgebildeten Oszillatoren (10,11) durch unterschiedlichen Wert einer frequenzbestimmenden Größe festgelegt sind und daß die Regelung der Frequenzen ($f_1$,$f_2$) durch

Einregelung des Wertes der frequenzbestimmenden Größe über das Frequenzvergleich-Ausgangssignal des PLL-Kreises (14,15,16) erfolgt.

4. Schaltungsanordnung nach Anspruch 3, **dadurch gekennzeichnet,** daß die frequenzbestimmende Größe durch eine in einem Emitterfolger ($T_3$) der Ringoszillatoren (10,11) liegende Verzögerungskapazität (Cd) gebildet ist und daß die Regelung durch das Frequenzvergleich-Ausgangssignal des PLL-Kreises (14,15,16) als Regelung des Emitterfolgerstroms erfolgt.

5. Schaltungsanordnung nach einem der Ansprüche 1 bis 4, **dadurch gekennzeichnet,** daß die Ringoszillatoren (10,11) in einem integrierten Schaltkreis elektrisch und geometrisch identisch und symmetrisch ausgebaut sind.

FIG 1

FIG 2

von Vergleichsstufe 15

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | WO-A-8 500 941 (ADVANCED MICRO DEVICES) <br> * Seite 3, Zeile 7 - Seite 16, Zeile 10; Figuren 1-6 * <br> --- | 1-5 | H 03 L 7/06 |
| X | US-A-4 131 861 (MALAVIYA) <br> * Spalte 1, Zeile 66 - Spalte 8, Zeile 47; Figuren 1-5 * <br> --- | 1 | |
| X | FR-A-2 487 607 (THOMSON-CSF) <br> * Seite 3, Zeile 32 - Seite 8, Zeile 2; Figur 2 * <br> --- | 1 | |
| X | US-A-4 675 617 (MARTIN) <br> * Spalte 1, Zeile 64 - Spalte 6, Zeile 19; Figuren 1,5 * <br> --- | 1 | |
| X | DE-A-3 328 420 (EPSON) <br> * Seite 14, Zeile 31 - Seite 18, Zeile 32; Figur 7 * <br> --- | 1 | |
| X | GB-A-1 173 203 (WANDEL U. GOLTERMANN) <br> * Seite 2, Zeile 118 - Seite 3, Zeile 96; Figuren 2-4 * <br> --- | 1 | |
| X | FR-A-2 143 558 (ADRET) <br> * Seite 2, Zeile 17 - Seite 7, Zeile 10; Figuren * <br> ----- | 1 | |

**RECHERCHIERTE SACHGEBIETE (Int. Cl.4)**

H 03 L

Der vorliegende Recherchenbericht wurde für alle Patentansprüche erstellt

| Recherchenort | Abschlußdatum der Recherche | Prüfer |
|---|---|---|
| DEN HAAG | 16-12-1988 | DHONDT I.E.E. |